# EUROPEAN PATENT SPECIFICATION

(11) **EP 2 717 342 B1**
(45) Date of publication and mention of the grant of the patent: **21.02.2018**
(21) Application number: 12789945.8
(22) Date of filing: 24.05.2012
(51) Int. Cl.: H01L 39/16, H01L 39/24, H02H 9/02

(54) **SUPERCONDUCTING ELEMENT FOR SUPERCONDUCTING CURRENT LIMITER, METHOD FOR MANUFACTURING SUPERCONDUCTING ELEMENT FOR SUPERCONDUCTING CURRENT LIMITER, AND SUPERCONDUCTING CURRENT LIMITER**
SUPRALEITENDES ELEMENT FÜR EINEN SUPRALEITENDEN STROMBEGRENZER, VERFAHREN ZUR HERSTELLUNG DES SUPRALEITENDEN ELEMENTS FÜR EINEN SUPRALEITENDEN STROMBEGRENZER SOWIE SUPRALEITENDER STROMBEGRENZER
ÉLÉMENT SUPERCONDUCTEUR POUR LIMITEUR DE COURANT SUPERCONDUCTEUR, MÉTHODE DE FABRICATION D'ÉLÉMENT SUPERCONDUCTEUR POUR LIMITEUR DE COURANT SUPERCONDUCTEUR ET LIMITEUR DE COURANT SUPERCONDUCTEUR

(30) Priority: 24.05.2011 JP 2011116283
(43) Date of publication of application: 09.04.2014
(73) Proprietor: Furukawa Electric Co., Ltd., Chiyoda-ku Tokyo 100-8322 (JP)
(72) Inventor: NAKAYAMA, Tomohiro, Tokyo 100-8322 (JP); ZHOU, Weiming, Tokyo 100-8322 (JP); KASAHARA, Hajime, Tokyo 100-8322 (JP); NAKAO, Kengo, Tokyo 100-8322 (JP); NAKAJIMA, Akifumi, Tokyo 100-8322 (JP); MATSUI, Masakazu, Tokyo 100-8322 (JP)
(74) Representative: Horn Kleimann Waitzhofer Patentanwälte PartG mbB
(86) International application number: PCT/JP2012/063374
(87) International publication number: WO 2012/161277

(56) References cited:
- JP-A- 5 251 761
- JP-A- 11 204 845
- JP-A- 2001 217 470
- JP-A- 2001 223 399
- JP-A- 2003 298 129
- JP-A- 2006 013 316
- US-A- 5 480 728
- US-A- 5 986 536
- US-A1- 2008 026 946

## Description

### Technical Field

The present invention relates to a superconducting element for a superconducting fault current limiter, a method for manufacturing a superconductive element for a superconducting fault current limiter, and a superconducting fault current limiter.

### Background Art

There have been hitherto used, as a superconducting element used for a superconducting fault current limiter, a superconducting element in which an intermediate layer and a superconducting layer are formed on a substrate, and an electrode is connected to the superconducting layer.

Here, as a method of fixing the electrode, a method of fixing the electrode on the superconducting layer using a solder containing indium, tin, or the like has been disclosed.

For example, Japanese Patent Application Laid-Open (JP-A) No. 05-251761 discloses a method of fixing a current lead on a superconducting film using an indium solder. US 5,986,536 discloses a resistive current-limiting device comprising at least one conductor for a predetermined rated current, formed by a layer of high-T_{c} superconducting material on an electrically insulating substrate and a carrier body. The conductor, substrate and carrier body form a multilayer structure. A plurality of electrically conducting contact surfaces are formed at ends of the conductor by burning in an Ag paste, for example.

JP-ANo. 2003-298129 discloses a superconducting member including a superconducting film provided on a base material, an electrode configured by a layered structure of an Au layer and an Ag layer and provided on the superconducting film, and a wire material connected to the superconducting film via a solder containing In, an In-Ag alloy, Sn, or an Sn-Ag alloy.

JP-ANo. 2009-211899 discloses a method in which when an electrode is joined to a superconductive conductor with a solder, a bonded portion between the superconductive conductor and a supporting member is soldered while cooling the bonded portion at a temperature lower than a thermal curing temperature of a conductive resin.

Further, as a method of fixing an electrode to a conductive thin film, a method of compressing a conductive thin film using indium to an electrode portion has been disclosed.

For example, JP-ANo. 11-204845 discloses a method in which, with regard to joining a conductive thin film and a thin film for an electrode, a conductive bump such as an In bump is interposed therebetween, and electrical and mechanical joining is carried out with the conductive bump.

### SUMMARY OF INVENTION

### Technical Problem

In superconducting elements for a superconducting fault current limiter, bonding of the electrode has been hitherto carried out by soldering using indium or the like, or by compression. However, in superconducting elements for a superconducting fault current limiter, when an overcurrent flows, quenching (switching from a superconducting state to a normal conducting state) is intentionally caused, and thus there is a problem in that indium or the like, which is used for stress mitigation during soldering or compression, diffuses to the inside of the superconducting layer due to Joule heat occurring upon the quenching, and breakage of an element occurs.

Accordingly, a method of bonding an electrode without using a member such as indium that diffuses to the inside of the superconducting layer has been demanded. However, in superconducting elements for a superconducting fault current limiter, the conducting state is changed from the superconducting state to the normal conducting state (a resistive element state) during quenching. Therefore, application of a large voltage to a superconducting element that has been in the normal conducting state causes generation of a large amount of Joule heat due to resistance. As a result, the temperature of the superconducting element greatly increases, a temperature cycle with a large variation in temperature occurs, and film-peeling occurs at a bonded portion between the electrode and the superconducting layer. Accordingly, in superconducting elements for a superconducting fault current limiter, there is demand for an electrode bonding structure having adhesiveness capable of enduring the temperature cycle even when bonding the electrode without using a member such as indium.

The invention has been made in consideration of the facts described above, and an object thereof is to provide a superconducting element for a superconducting fault current limiter in which occurrence of film-peeling due to a temperature cycle caused by quenching is suppressed, a method for manufacturing the superconducting element for a superconducting fault current limiter, and a superconducting fault current limiter provided with the superconducting element for a superconducting fault current limiter.

### Solution to Problem

The problem of the invention has been solved by the following means.
<1> A superconducting element for a superconducting fault current limiter, comprising: a substrate; an intermediate layer that is formed on the substrate; a superconducting layer that is formed on the intermediate layer; an electrode that is connected to the superconducting layer; and a metal fine particle sintered layer that is interposed between the superconducting layer and the electrode and that connects the superconducting layer and the electrode, wherein:
   a surface roughness Ra of a surface that is in contact with the metal fine particle sintered layer, of a layer at a substrate side among layers adjacent to the metal fine particle sintered layer, is 100 nm or less; and a particle diameter of metal fine particles that form the metal fine particle sintered layer is less than the surface roughness Ra.
<2> The superconducting element for a superconducting fault current limiter according to <1>, wherein the metal fine particle sintered layer is configured with metal fine particles of a simple substance metal or alloy including at least one selected from the group consisting of Ag, Au, Cu, and Pt.
<3> The superconducting element for a superconducting fault current limiter according to any one of <1> to <2>, further comprising a metal protective film provided between the superconducting layer and the metal fine particle sintered layer.
<4> The superconducting element for a superconducting fault current limiter according to any one of <1> to <3>, wherein the superconducting layer comprises, as a main component, an oxide superconductor represented by a compositional formula of REBa₂Cu₃O_{7-δ}, wherein RE represents a single rare-earth element or a plurality of rare-earth elements, and δ is an oxygen non-stoichiometric amount.
<5> The superconducting element for a superconducting fault current limiter according to <4>, wherein: the substrate is a sapphire substrate; and the intermediate layer is configured to include at least one selected from the group consisting of CeO₂ and REMnO₃, wherein RE represents a single rare-earth element or a plurality of rare-earth elements.
<6> A method for manufacturing a superconducting element for a superconducting fault current limiter, the method comprising, in the following order: an intermediate layer forming process of forming an intermediate layer on a substrate; a superconducting layer forming process of forming a superconducting layer on the intermediate layer; a metal fine particle film forming process of forming a metal fine particle film containing metal fine particles on at least a part of the superconducting layer; an electrode connecting process of connecting an electrode to the superconducting layer via the metal fine particle film; and a sintering process of sintering the metal fine particles of the metal fine particle film to form a metal fine particle sintered layer, wherein, at a stage before the metal fine particle film forming process, a surface roughness Ra of a surface that comes into contact with the metal fine particle film, of a layer adjacent to the metal fine particle film, is adjusted to 100 nm or less, and a particle diameter of the metal fine particles that are used in the metal fine particle film forming process is less than the surface roughness Ra.
<7> The method for manufacturing a superconducting element for a superconducting fault current limiter according to <6>, wherein the metal fine particles that are used in the metal fine particle film forming process are fine particles of a simple substance metal or alloy including at least one selected from the group consisting of Ag, Au, Cu, and Pt.
<8> The method for manufacturing a superconducting element for a superconducting fault current limiter according to any one of <6> or <7>, further comprising a metal protective film forming process of forming a metal protective film on the superconducting layer, after the superconducting layer forming process and before the metal fine particle film forming process.
<9> The method for manufacturing a superconducting element for a superconducting fault current limiter according to any one of <6> to <8>, wherein a superconducting layer containing, as a main component, an oxide superconductor represented by a compositional formula of REBa₂Cu₃O_{7-δ}, wherein RE represents a single rare-earth element or a plurality of rare-earth elements, and δ is an oxygen non-stoichiometric amount, is formed in the superconducting layer forming process.
<10> The method for manufacturing a superconducting element for a superconducting fault current limiter according to <9>, wherein the substrate is a sapphire substrate; and an intermediate layer including at least one selected from the group consisting of CeO₂ and REMnO₃, wherein RE represents a single rare-earth element or a plurality of rare-earth elements, is formed in the intermediate layer forming process.
<11> A superconducting fault current limiter, comprising: a sealed container into which liquid nitrogen is filled; a current input and output unit that inputs a current to the inside of the sealed container from the outside and outputs the current; and a superconducting fault current limiting element that is configured using the superconducting element according to any one of <1> to <5>, and is connected to the current input and output unit inside the sealed container.

### Advantageous Effects of Invention

According to the invention, it is possible to provide a superconducting element for a superconducting fault current limiter in which occurrence of film-peeling due to a temperature cycle caused by quenching is suppressed, a method for manufacturing the superconducting element for a superconducting fault current limiter, and a superconducting fault current limiter provided with the superconducting element for a superconducting fault current limiter.

### BRIEF DESCRIPTION OF DRAWINGS

Fig. 1 is a schematic configuration diagram of a superconducting fault current limiter according to an embodiment of the invention.
Fig. 2 is a cross-sectional diagram illustrating a cross-sectional structure of a superconducting element according to an embodiment of the invention.
Fig. 3A is an image obtained by photographing a surface of a superconducting layer that is formed in Example 1.
Fig. 3B is an image obtained by photographing a surface of a metal protective film that is formed in Example 1.
Fig. 4 is a cross-section diagram illustrating a cross-sectional structure of a superconducting element that is formed in Comparative Example 2.

### DESCRIPTION OF EMBODIMENTS

Hereinafter, a superconducting element for a superconducting fault current limiter, a method for manufacturing the same, and a superconducting fault current limiter according to an embodiment of the invention are described in detail with reference to the attached drawings. In the drawings, the same reference numerals are given to members (constituent elements) having the same or corresponding functions, and description thereof is omitted as appropriate.

### <Superconducting Fault Current Limiter>

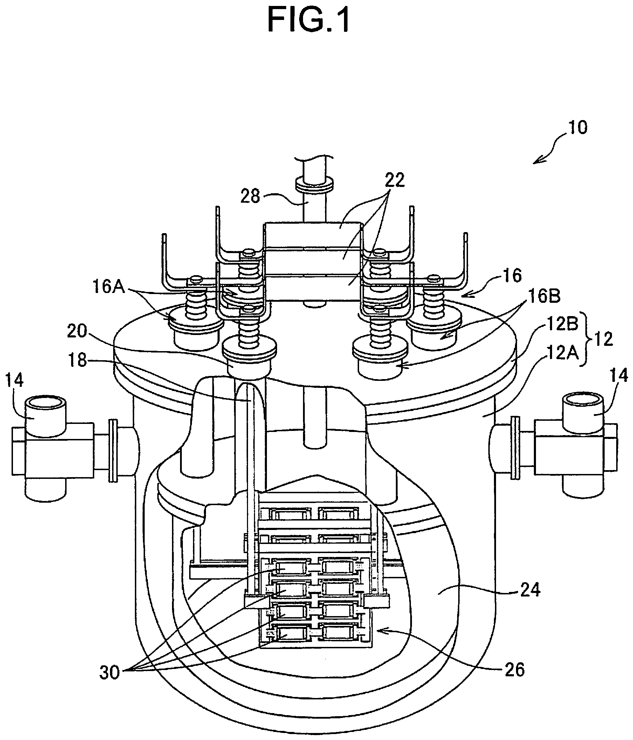

Fig. 1 shows a schematic configuration diagram of a superconducting fault current limiter 10 according to an embodiment of the invention.

The superconducting fault current limiter 10 according to an embodiment of the invention is an apparatus having functions in which, by utilizing S/N transitions (superconducting-normal state transitions) of the superconductor, the superconducting fault current limiter is usually in a zero resistance state, and forms a high resistance state when an over-current equal to or higher than a threshold current flows, thereby suppressing an over-current.

The superconducting fault current limiter 10 includes a sealed container 12 that is sealed by closing a container main body 12A with a lid 12B.

A refrigerator 14 is connected to the container main body 12A, and liquid nitrogen is introduced to the inside of the sealed container 12 from the refrigerator 14. A current input and output unit 16 that inputs a current to the inside of the sealed container 12 from the outside and outputs the current is connected to the lid 12B. The current input and output unit 16 is configured to form a three-phase alternating current circuit. Specifically, the current input and output unit 16 is configured to include three current input portions 16A and three current output portions 16B corresponding to the three current input portions 16A.

Each of the current input portions 16A and the current output portions 16B is configured with a conducting wire 18 that penetrates through the lid 12B and extends in the vertical direction, and a cylindrical body 20 that covers the conducting wire 18.

One end of the conducting wire 18 of the current input portion 16A, which is exposed to the outside, is connected to one end of the conducting wire 18 of the corresponding current output portion 16B, which is exposed to the outside, via an external resistor 22 as a shunt resistor.

An element accommodating container 24 is supported by an end of each of the cylindrical bodies 20, which is located inside the container main body 12A.

The element accommodating container 24 is disposed in the sealed container 12, and is cooled to the inside thereof by liquid nitrogen that is filled in the sealed container 12.

A fault current limiter unit 26 configured with plural thin film type superconducting elements 30 is disposed in the element accommodating container 24. In an embodiment of the invention, specifically, the thin film superconducting elements 30 arranged in 4 rows × 2 columns make up one set, and three sets constitute the fault current limiter unit 26.

The fault current limiter unit 26 is supported by the other end of each of the conducting wires 18 of the current input portions 16A, which is located inside, the other end of each of the conducting wires 18 of the current output portions 16B, which is located inside, and a support column 28. The other end of the conducting wire 18 of the current input portion 16A which is located inside and the other end of the conducting wire 18 of the current output portion 16B which is disposed in the inside are electrically connected to each other via the thin film type superconducting elements 30 so as to form a three-phase alternating current circuit.

### <Superconducting Element>

Next, the outline of the thin film type superconducting elements 30 is described.

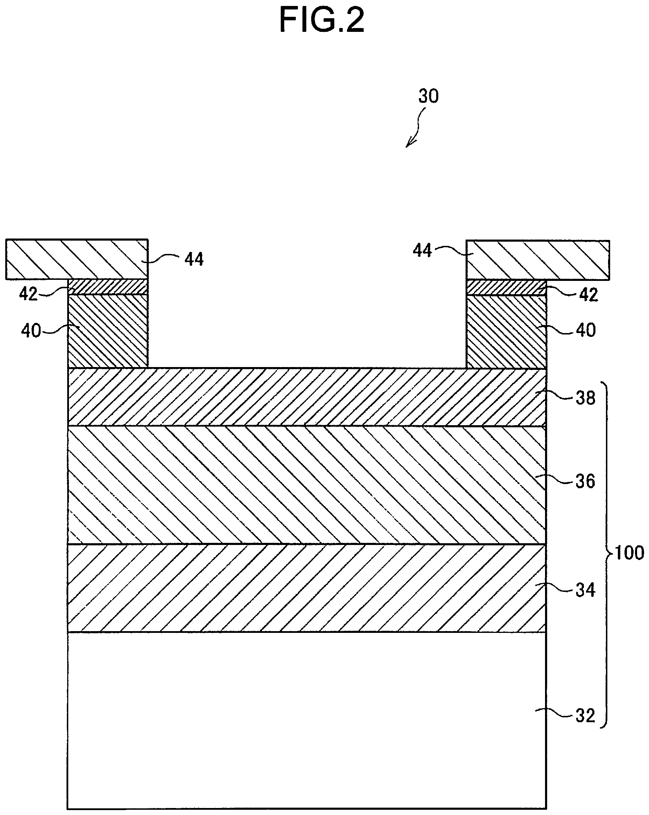

Fig. 2 shows a diagram illustrating a cross-sectional structure of the thin film type superconducting elements 30 according to an embodiment of the invention.

As illustrated in Fig. 2, the thin film type superconducting element 30 includes a superconducting thin film 100 having a multi-layered structure in which an intermediate layer 34, a superconducting layer 36, and a metal protective film 38 are formed on a substrate 32 in this order. In addition, a pair of electrodes 44 that are electrically connected to the above-described conducting wire 18 is disposed on the metal protective film 38, and the electrodes 44 are fixed onto the metal protective film 38 via a metal fine particle sintered layer 40 interposed therebetween. In addition, a metal coat layer 42 is formed between the metal fine particle sintered layer 40 and each of the electrodes 44.

### (Metal Fine Particle Sintered Layer)

The metal fine particle sintered layer 40 is a layer that is interposed between the superconducting layer 36 and the electrode 44 and connects the superconducting layer 36 and the electrode 44 to each other. The metal fine particle sintered layer 40 plays a role of bonding an adjacent layer (the metal protective film 38 in Fig. 2) on a superconducting layer 36 side and an adjacent layer (the metal coat layer 42 in Fig. 2) on an electrode 44 side. The metal fine particle sintered layer 40 is formed by sintering metal fine particles.

In the superconducting element for a superconducting fault current limiter, the conducting state is changed from a superconducting state to a normal conducting state (a resistive element state) during quenching. Therefore, application of a large voltage to the superconducting element that has been in the normal conducting state causes generation of a large amount of Joule heat due to resistance. As a result, a temperature of the superconducting element largely increases (for example, a temperature variation by approximately 100°C from a temperature under liquid nitrogen (-196°C) occurs), and a temperature cycle in which a variation in temperature is large occurs. Therefore, even in a case of bonding the electrode to the superconducting element, in the superconducting element that is used for the superconducting fault current limiter, there is a demand for an electrode bonding structure having adhesiveness capable of enduring against the temperature cycle.

In this regard, in the embodiment, as a layer that is interposed between the superconducting layer 36 and the electrode 44 and connects the superconducting layer 36 and the electrode 44 to each other, the metal fine particle sintered layer 40 formed sintering the metal fine particles is provided. Since each of the adjacent layer (the metal protective film 38 in Fig. 2) on the superconducting layer 36 side and the adjacent layer (the metal coat layer 42 in Fig. 2) on the electrode 44 side has strong adhesivity with the metal fine particle sintered layer 40, occurrence of film-peeling in a layer between the superconducting layer 36 and the electrode 44 due to the temperature cycle caused by quenching is suppressed.

In addition, since the metal fine particle sintered layer 40 is provided between the superconducting layer 36 and the electrode 44, the electrode 44 can be connected to the superconducting layer 36 without using a member such as indium that diffuses to the inside of the superconducting layer. Accordingly, breakage of an element that occurs due to diffusion of the indium and the like to the inside of the superconducting layer is prevented.

Furthermore, the superconducting layer 36 and the electrode 44 can be connected to each other by a simple configuration in which the metal fine particle sintered layer 40 is interposed between the superconducting layer 36 and the electrode 44, and thus the weight or volume of the superconducting element can be reduced. Accordingly, the freedom of design of the superconducting fault current limiter can be improved.

In the superconducting fault current limiter, a cooling mechanism for realizing a temperature under the liquid nitrogen temperature is necessary. If the weight or volume of the superconducting element can be reduced, the freedom of design of the cooling mechanism such as arrangement of the element inside the cooling mechanism, weight resistance of the cooling mechanism, and an amount of liquid nitrogen can be improved.

### • Particle Diameter

A particle diameter of the metal fine particles that are used for forming the metal fine particle sintered layer 40 is preferably 150 nm or less considering that sintering is possible at a low temperature, and, therefore, deterioration in element characteristics is suppressed. The particle diameter of the metal fine particles is more preferably 100 nm or less in consideration of further improvement of a low temperature sintering property.

In this specification, the particle diameter of the metal fine particles represents a number-average particle diameter.

Generally, the particle diameter of the metal fine particles is measured by direct observation using an electron beam microscope and the like. A value provided from a material manufacturer may also be used. (For example, in a case of silver nanoparticles (NPS) manufactured by Harima Chemicals Group, Inc., "average particle diameter is 12 nm (a range of a particle diameter is from 8 nm to 15 nm)" is described.)

It is preferable that the particle diameter of the metal fine particles be less than the surface roughness Ra of a surface, which comes into contact with the metal fine particle sintered layer 40, of a layer (hereinafter, simply referred to as a "substrate-side adjacent layer") on a substrate 32 side among the layers adjacent to the metal fine particle sintered layer 40. An example of the substrate-side adjacent layer may be the metal protective film 38 as illustrated in Fig. 2. However, in an embodiment, the metal protective film 38 is not provided, and the superconducting layer 36 and the metal fine particle sintered layer 40 may be adjacent to each other, and in this case, the substrate-side adjacent layer is the superconducting layer 36. The surface roughness Ra of the substrate-side adjacent layer is preferably 100 nm or less in consideration of improvement of a threshold current value.

It is thought that when the particle diameter of the metal fine particles is less than the surface roughness Ra of the substrate-side adjacent layer, the metal fine particles before the sintering fall into unevenness in the surface of the substrate-side adjacent layer, and the sintering is carried out in a state in which the metal fine particles are buried in the unevenness, whereby the metal fine particle sintered layer 40 is formed. Accordingly, it is thought that a higher adhesiveness is obtained due to the increase in a contact area between the metal fine particle sintered layer 40 and the substrate-side adjacent layer.

It is more preferable that the maximum particle diameter of the metal fine particles be less than the surface roughness Ra of the substrate-side adjacent layer. The maximum particle diameter of the metal fine particles is a maximum value measured by direct observation using an electron beam microscope, or a maximum value of the values provided from a material manufacturer.

### • Material

Examples of a material of the metal fine particles include, but not particularly limited to, a simple substance metal or an alloy including at least one selected from Ag, Au, Cu or Pt. Among these, particularly, the Ag simple substance metal is preferable in consideration of a low electrical resistance value in the liquid nitrogen temperature region.

The thickness of the metal fine particle sintered layer 40 is not particularly limited, but the thickness is preferably from 1 µm to 10 µm in consideration of a low contact resistance.

### (Electrode and Metal Coat Layer)

Examples of a material of the pair of electrodes 44 include a conductive member, such as a simple substance metal such as copper, gold, or silver, or an alloy including thereof. Examples of a shape of each of the electrodes 44 include a sheet shape, a net shape, and a block shape

From the viewpoint of affinity between the electrode 44 and the components of the metal fine particles, the metal coat layer 42 which contains a material having affinity with the metal fine particles as a main component may be interposed between the electrode 44 and the metal fine particle sintered layer 40. Examples of the metal coat layer 42 include silver plating, and the metal coat layer 42 is formed according to a known method of the related art. The thickness of the metal coat layer 42 is not particularly limited, but the thickness is preferably from 1 µm to 5 µm in consideration of adhesiveness between the electrode 44 and the metal coat layer 42.

### Next, a configuration of the superconducting thin film 100 illustrated in Fig. 2 is described.

### (Substrate)

The substrate 32 has a single crystalline structure of metal oxide or ceramic. As the shape of the substrate 32, any of various shapes may be employed as long as a main surface on which a film for the superconducting layer 36 is formed is provided on a surface. It is preferable to employ a rectangular flat shape in consideration of easy handling.

The thickness of the substrate 32 is not particularly limited, but the thickness is, for example, 1 mm.

### • Composition

Specific examples of the metal oxides include Al₂O₃ (aluminum oxide, particularly, sapphire, (Zr, Y)O₂ (yttria stabilized zirconia), LaAlO₃ (lanthanum aluminate), SrTiO₃ (strontium titanate), (LaₓSr₁₋ₓ)(AlₓTa₁₋ₓ)O₃ (lanthanum oxide strontium aluminum tantalum), NdGaO₃ (neodymium gallate), YAlO₃ (yttrium aluminate), MgO (magnesium oxide), TiO₂ (titania), BaTiO₃ (barium titanate). Specific examples of the ceramics include silicon carbide and graphite.

Particularly, among these, it is preferable to employ a sapphire substrate in consideration of high strength and thermal conductivity.

### (Intermediate Layer)

The intermediate layer 34 is a layer that is formed on the substrate 32 for realizing high in-plane orientation in the superconducting layer 36, and may be configured as a single layer film or a multi-layer film.

The intermediate layer 34 is not particularly limited. However, specifically, it is preferable that the intermediate layer 34 be configured to include at least one selected from CeO₂ or REMnO₃. RE represents a single rare-earth element or plural rare-earth elements such as Y, Nd, Sm, Eu, Gd, Dy, Ho, Er, Tm, Yb, and Lu.

Although the film thickness of the intermediate layer 34 is not particularly limited, the film thickness of the intermediate layer 34 is, for example, 20 nm.

### (Superconducting Layer)

The superconducting layer 36 is formed on the intermediate layer 34, and is configured with an oxide superconductor, preferably, a copper oxide superconductor.

As the copper oxide superconductor, a crystalline material represented by a compositional formula such as REBa₂Cu₃O₇₋₅ (referred to as RE-123), Bi₂Sr₂CaCu₂O_{8+δ} (including a compound in which Pb or the like is doped to a Bi site), Bi₂Sr₂Ca₂Cu₃O_{10+δ} (including a compound in which Pb or the like is doped to a Bi site), (La, Ba)₂CuO_{4-δ}, (Ca, Sr)CuO_{2-δ} [a Ca site may be Ba], (Nd, Ce)₂CuO_{4-δ}, (Cu, Mo)Sr₂(Ce, Y)ₛCu₂O [referred to as (Cu, Mo)-12s2, s = 1, 2, 3, or 4], Ba(Pb, Bi)O₃, or Tl₂Ba₂Caₙ₋₁CuₙO₂ₙ₊₄ (n is an integer of 2 or more) may be used. The copper oxide superconductor may be configured as any combination of these crystalline materials.

RE in REBa₂Cu₃U_{7-δ} represents a single rare-earth element or plural rare-earth elements such as Y, Nd, Sm, Eu, Gd, Dy, Ho, Er, Tm, Yb, and Lu, and among these, RE is preferably Y considering that substitution with a Ba site does not occur, and a superconducting transition temperature Tc is high, and the like. δ represents an oxygen non-stoichiometric amount, and is from 0 to 1, for example. It is preferable that δ be close to 0 as possible from the viewpoint that the superconducting transition temperature is high. With regard to the oxygen non-stoichiometric amount, when high-pressure oxygen annealing or the like is carried out using an apparatus such as an autoclave, δ may be less than 0, that is, may be a negative value.

Currently, a superconducting phenomenon is not confirmed in prBa₂Cu₃O_{7.δ} in which RE is Pr, a superconducting phenomenon has not been confirmed, but in a case where the superconducting phenomenon is confirmed in PrBa₂Cu₃O_{7-δ} in which RE is Pr in the future, by, for example, controlling the oxygen non-stoichiometric amount δ, the PrBa₂Cu₃O_{7-δ} is also included in the oxide superconductor according to the embodiment of the invention.

δ of crystalline materials other than REBa₂Cu₃O_{7-δ} also represents an oxygen non-stoichiometric amount, and for example δ is from 0 to 1.

It is preferable that the superconducting layer 36 includes the oxide superconductor represented by REBa₂Cu₃O_{7-δ} as a main component. The "main component" represents a component of which content is the largest among the constituent components contained in the superconducting layer 36, and preferably, the main component has the content of 50% or more.

Although not particularly limited, for example, the film thickness of the superconducting layer 36 is 200 nm.

### • Surface Roughness Ra

In a case in which the superconducting element 30 according to the embodiment does not include the metal protective film 38, and the superconducting layer 36 and the metal fine particle sintered layer 40 are adjacent to each other, the surface roughness Ra of at least a surface of the superconducting layer 36 which comes into contact with the metal fine particle sintered layer 40 is preferably 100 nm or less in consideration of improvement of a threshold current value, and more preferably 50 nm or less.

The measurement of the surface roughness Ra is carried out in a scanning range of 10 µm × 10 µm using a scanning probe microscope (SPM).

Examples of a method of controlling the surface roughness Ra of the superconducting layer 36 in the above-described range include the following methods. In a forming method (wet process) in which a coating liquid is applied and sintering is carried out, the surface roughness Ra is controlled by a solution concentration of the coating liquid, the number of rotation of a substrate during application by spin coating, a sintering temperature, and the like. In a forming method (dry process) by a PLD (Pulse Laser Deposition) method, a CVD (Chemical Vapor Deposition) method, or the like, the surface roughness Ra is controlled by a film forming speed, a flow rate of a raw material gas, a substrate temperature, and the like. Examples of the method of controlling the surface roughness Ra further include a method of forming unevenness in the surface of the formed superconducting layer 36 in a physical manner using plasma or the like.

### (Metal Protective Film)

The metal protective film 38 may be formed on the surface of the superconducting layer 36. Examples of a material of the metal protective film 38 include a conductive member of, of example, a simple substance metal such as gold, silver, or copper, or an alloy containing thereof. Although not particularly limited, the film thickness of the metal protective film 38 is preferably from 100 nm to 300 nm in consideration of protection against moisture in the air and voltage resistant design.

### • Surface Roughness Ra

In the superconducting element 30 according to the embodiment, in a case where a layer adjacent to the metal fine particle sintered layer 40 is the metal protective film 38, the surface roughness Ra of the surface of the metal protective film 38 which comes into contact with the metal fine particle sintered layer 40 is preferably 100 nm or less, and more preferably 50 nm or less, in consideration of improvement of adhesiveness due to transfer of unevenness of the superconducting layer and also in consideration of improvement of a threshold current value.

The surface roughness Ra is measured by the same method as the measurement of the surface roughness Ra of the superconducting layer as described above.

Examples of a method of controlling the surface roughness Ra of the metal protective film 38 in the above-described range include a control method in which after controlling the surface roughness Ra of the superconducting layer 36 by the above-described method, the metal protective film 38 is formed in the above-described film thickness range, or a method in which after forming the metal protective film 38, unevenness is physically formed on the surface of the metal protective film 38 by plasma or the like.

### <Method of Manufacturing Superconducting Element>

Next, a method of manufacturing the superconducting element 30 will be described in detail.

### - Intermediate Layer Forming Process -

First, an intermediate layer forming process of forming an intermediate layer is carried out with respect to the substrate 32 that has been polished. As a method of forming the intermediate layer 34, for example, a PLD method, a CVD method, an MOCVD (Metal Organic Chemical Vapor Deposition) method, an IBAD (Ion Beam Assisted Deposition) method, a TFA-MOD (Tri Fluoro Acetates-Metal Organic Deposition) method, a sputtering method, an electron beam deposition method, or the like may be used. Among these, it is preferable to use the IBAD method in that high orientation can be realized. In addition, it is preferable to use the electron beam deposition method in that high-efficiency film formation can be realized.

As the intermediate layer forming process, for example, in a case of using the electron beam deposition method, plasma is generated in oxygen of from 1 × 10⁻² Pa to 1 × 10⁻¹ Pa, and in a state in which the substrate 32 is heated to 700°C or higher, a film formed of, for example, CeO₂ is deposited on the substrate 32 in a range of from 10 nm to 20 nm, thereby forming the intermediate layer 34.

### - Superconducting Layer Forming Process -

Next, a superconducting layer forming process is carried out. Examples of a method of forming (film-forming) the superconducting layer 36 include a PLD method, a CVD method, an MOCVD method, an MOD method, a sputtering method. Among these film forming method, it is preferable to use the MOCVD method in that high vacuum is not necessary, film formation is possible even in the substrate 32 having a large area and a complicated shape, and mass production is excellent. It is preferable to use the MOD method in that film formation may be realized with high-efficiency.

For example, in a case of forming the superconducting layer 36 formed of YBCO using, for example, the MOD method in the superconducting layer forming process, first, a solution of an organic complex of yttrium, barium, and copper is applied on a surface of the intermediate layer 34 using a spin coater to form a precursor film. Then, the precursor film is pre-baked, for example, at from 300°C to 600°C in the air.

After an organic solvent is removed by the pre-baking, the precursor film is subjected to final-baking at from 700°C to 900°C, thereby obtaining the superconducting layer 36 composed of a YBCO oxide superconductor from the precursor film.

In the final-baking, first, baking may be carried out in an inert atmosphere, and the atmosphere may be converted to an oxygen atmosphere from the middle of the final-baking.

### - Metal Protective Film Forming Process -

The metal protective film 38 formed of a conductive member such as a gold-silver alloy is formed on the obtained superconducting layer 36. Examples of a method of forming the metal protective film 38 include a sputtering method, a vacuum deposition method, and among these, the sputtering method is preferable.

### - Metal Fine Particle Film Forming Process -

In a case of having the metal protective film 38, the metal fine particle film is formed on at least at a part of a surface of the metal protective film 38, using a coating liquid containing metal fine particles such as silver nanoparticles, by a coating method. In a case of not having the metal protective film 38, the metal fine particle film is formed on at least at a part of a surface of the superconducting layer 36, using a coating liquid containing metal fine particles such as silver nanoparticles , by a coating method.

Examples of the coating method of the coating liquid include a screen printing method, and an ink-jet method.

### - Electrode Connection Process -

Next, the electrode 44 is temporarily connected onto the metal fine particle film.

In a case of providing the metal coat layer 42 between the electrode 44 and the metal fine particle sintered layer 40, the metal coat layer 42 may be formed in advance on the electrode 44 by an electroplating method before the temporary connection of the electrode 44.

### - Sintering Process -

Sintering is carried out in a state in which the electrode 44 and the metal fine particle film are temporarily connected to each other, thereby forming the metal fine particle sintered layer 40. The sintering is preferably carried out under the atmospheric atmosphere or an oxygen atmosphere at a temperature of 350°C or lower in consideration of suppressing deterioration of element characteristics of the superconducting layer 36 due to generation of oxygen defect.

In this manner, the superconducting element for a superconducting fault current limiter according to the embodiment of the invention is manufactured.

### <Modification Example>

The invention is described in detail with reference to specific embodiments, but the invention is not limited to the embodiment, and it is obvious to a person skilled in the art that that various embodiments may be made within the scope of the invention. For example, plural embodiments mentioned above may be appropriately carried out in combination. In addition, the following modification examples may be appropriately combined. film are temporarily connected to each other, thereby forming the metal fine particle sintered layer 40. The sintering is preferably carried out under the atmospheric atmosphere or an oxygen atmosphere at a temperature of 350°C or lower in consideration of suppressing deterioration of element characteristics of the superconducting layer 36 due to generation of oxygen defect.

In this manner, the superconducting element for a superconducting fault current limiter according to the embodiment of the invention is manufactured.

### <Modification Example>

The invention is described in detail with reference to specific embodiments, but the invention is not limited to the embodiment, and it is obvious to a person skilled in the art that that various embodiments may be made within the scope of the invention. For example, plural embodiments mentioned above may be appropriately carried out in combination. In addition, the following modification examples may be appropriately combined.

For example, the intermediate layer 34 may be formed on the substrate 32 so as to have another layer interposed between the intermediate layer 34 and the substrate.

The metal protective film 38 or the metal coat layer 42 may be also appropriately omitted.

### Examples

Hereinafter, description is given to the superconducting element for a superconducting fault current limiter according to the invention with reference to examples, but the invention is not limited by these examples. Only Examples 1-5 are embodiments according to the claimed invention.

### <Example 1>

### • Formation of Intermediate Layer

A commercially available polished R-plane sapphire substrate (one-side-polished sapphire substrate manufactured by KYOCERA Corporation, size: 210 mm × 30 mm × 1 mm) was used, and a thin film of cerium oxide (CeO₂) was deposited on the sapphire substrate in a thickness of 15 nm by EB (Electron Beam) deposition while heating the polished R-plane

### • Formation of Metal Protective Film

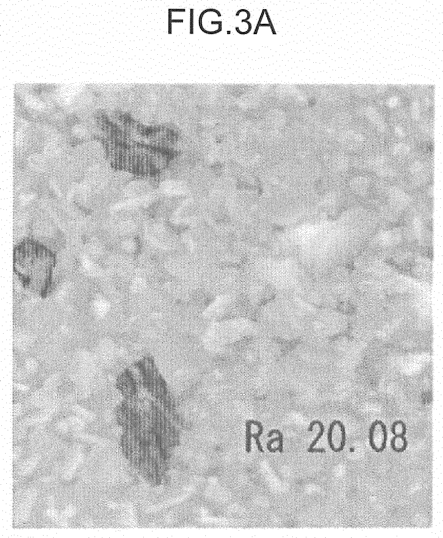

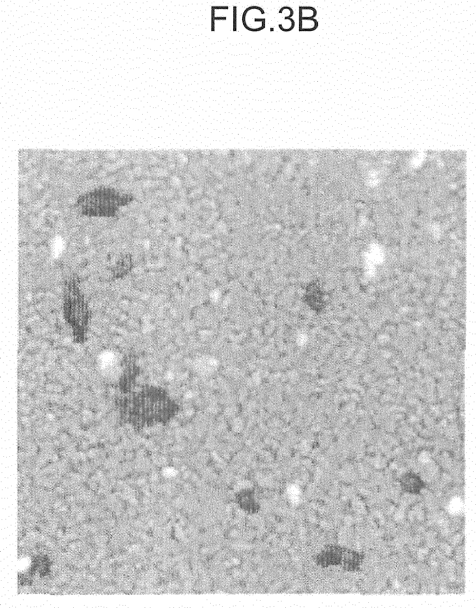

A metal protective film formed of gold-silver alloy (Au- Ag of 23 atm%) was formed on the obtained superconducting layer by a sputtering method in a film thickness of 300 nm. In addition, the surface roughness of the superconducting layer was transferred to the surface of the metal protective film, and the surface roughness Ra of the metal protective film was 20 nm. An image obtained by photographing the surface of the metal protective film is illustrated in Fig. 3B.

### • Formation of Metal Fine Particle Film and Sintering (Formation of Metal Fine Particle Sintered Layer)

As metal fine particles, silver nanoparticles (NPS manufactured by Harima Chemicals Group, Inc., "average particle diameter is 12 nm) was used, and a metal fine particle film was formed by a screen printing method. Then, sintering was carried out in an oxygen atmosphere at 230°C to form a metal fine particle sintered layer. The film thickness of the metal fine particle sintered layer that was formed by sintering was measured using a step gauge (CS-5000, manufactured by Mitutoyo Corporation), and it was found to be in a range of 9.7 µm to 10.4 µm.

In this manner, a superconducting element for evaluation of adhesiveness was obtained.

### - Evaluation of Adhesiveness -

The obtained superconducting element was cooled with liquid nitrogen, and then the temperature thereof was returned to room temperature, thereby applying a temperature variation (approximately 300°C) larger than a temperature cycle with a temperature variation (approximately 100°C) when quenching occurs. However, film-peeling did not occur between the metal fine particle sintered layer and the metal protective film.

### <Comparative Example 1>

A superconducting element for evaluation of adhesiveness was obtained by the same method described in Example 1 except that the metal fine particle sintered layer in Example 1 was changed to a silver deposition film formed by depositing silver, and the above-described sintering in Example 1 was not carried out.

### - Evaluation of Adhesiveness -

As is the case with Example, the obtained superconducting element was cooled with liquid nitrogen, and then the temperature thereof was returned to room temperature, thereby applying a temperature variation larger than a temperature cycle accompanied with a temperature variation when quenching occurs. At this time, film-peeling occurred between the silver deposition film and the metal protective film.

### <Comparative Example 2>

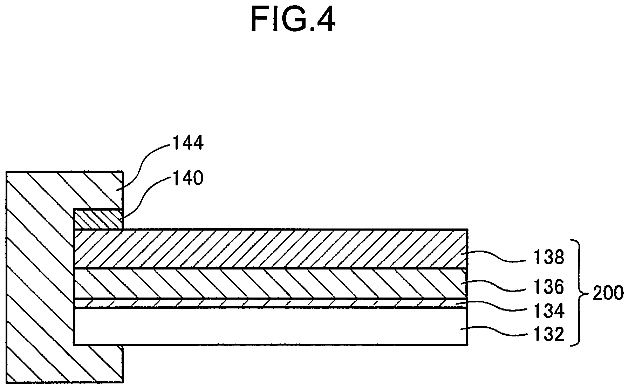

A superconducting element illustrated in Fig. 4 was prepared, in which as an electrode fixing method, the electrode and the superconducting thin film were compressed using indium.

Specifically, the method of Example 1 up to the "formation of the metal protective film" in Example 1 was carried in the same manner as Example 1, thereby forming a superconducting thin film 200 including a substrate 132 (sapphire), an intermediate layer 134 (cerium oxide), a superconducting layer 136 (YBCO), and a metal protective film 138 (gold-silver alloy).

Next, as illustrated in Fig. 4, a copper block as an electrode 144 and an end of the superconducting thin film 200 were compressed in a state in which an In-sheet 140 was interposed therebetween to fix the copper block to the superconducting thin film 200, thereby obtaining a superconducting element.

### - Evaluation of Weight -

The weight comparison between the superconducting element of Comparative Example 2 and the superconducting element of Example 1 was carried out. In the superconducting element of Comparative Example 2 in which the electrode was fixed by compression, the weight was 420 g. On the contrary, in the superconducting element of Example 1 in which the electrode was fixed using the metal fine particle sintered layer, the weight was 80 g. From this result, it was found that the weight was reduced by approximately 80% in Example 1.

### <Examples 2 to 15>

Superconducting elements were formed in the same manner as Example 1 except that metal fine particles with a different average fine particle diameter and metal protective films with a different surface roughness Ra were prepared.

Specifically, the superconducting elements of Examples 2 to 15 were formed while changing an average particle diameter of metal fine particles that were used and the surface roughness Ra of the metal protective films as illustrated in Table 1.

With respect to the obtained superconducting elements of Examples 1 to 15 and Comparative Example 1, evaluation of adhesiveness and evaluation of a threshold current value were carried out.

### - Evaluation of Adhesiveness -

With regard to evaluation of adhesiveness, the obtained superconducting elements were cooled with liquid nitrogen, and then the temperatures thereof were returned to room temperature, thereby applying a temperature variation (approximately 300°C) larger than a temperature cycle accompanied with a temperature variation (approximately 100°C) when quenching occurs. Then, evaluation of a film-peeling state between the metal fine particle sintered layer and the metal protective film was carried out using an optical microscope.

The following evaluation criteria were provided according to the film-peeling state.
- A: Film-peeling does not occur at all.
- B: The area of a film-peeled portion is less than 5%.
- C: The area of the film-peeled portion is equal to or more than 5% and less than 10%.
- D: The area of the film-peeled portion is 10% or more.

### - Evaluation of Threshold Current Value -

Evaluation of a threshold current value was carried out separately from the evaluation of the adhesiveness. In this evaluation, each of elements was immersed in liquid nitrogen, a current value was changed, and evaluation was carried out using current-voltage characteristics at that time.

The following evaluation criteria were provided with respect to the evaluation of the threshold current value.
- A: 100 A or more.
- B: Equal to or more than 80 A and less than 100 A.
- C: Equal to or more than 50 A and less than 80 A.
- D: Less than 50 A.

**Table 1**

| | Particle diameter of metal fine particles (nm) | Surface roughness Ra (nm) of metal protective film | Adhesiveness | Threshold Current Value |
|---|---|---|---|---|
| Example 1 | 12 | 20 | A | A |
| Example 2 | 35 | 45 | A | A |
| Example 3 | 50 | 76 | A | B |
| Example 4 | 70 | 83 | A | B |
| Example 5 | 80 | 100 | A | B |
| Example 6 | 90 | 120 | B | _{C} |
| Example 7 | 100 | 135 | B | C |
| Example 8 | 110 | 141 | B | C |
| Example 9 | 12 | 9 | B | A |
| Example 10 | 35 | 20 | C | A |
| Example 11 | 50 | 45 | C | A |
| Example 12 | 76 | 70 | B | B |
| Example 13 | 80 | 76 | B | B |
| Example 14 | 90 | 76 | C | B |
| Example 15 | 100 | 83 | C | B |
| Comparative Example 1 | - | 20 | D | A |

As can be seen from Table 1, in a case where the surface roughness Ra of the metal protective film is 100 nm or less and the particle diameter of the metal fine particles is less than Ra, the combination of evaluation results of of adhesiveness and the threshold current value is A-A to A-B, or B-A, which shows high adhesiveness and satisfactory threshold current value.

It can be seen that in a case where the surface roughness Ra of the metal protective film is 45 nm or less and the particle diameter of the metal fine particles is less than Ra, the threshold current value is further improved and high adhesiveness and high threshold current value are exhibited, and thus this case is particularly preferable.

### Reference Signs

10: Superconducting fault current limiter
12: Sealed container
16: Current input and output unit
24: Element accommodating container
30: Thin film type superconducting element (superconducting fault current limiter element)
32, 132: Substrate
34, 134: Intermediate layer
36, 136: Superconducting layer
38, 138: Metal protective film
40: Metal fine particle sintered layer
42: Metal coat layer
44, 144: Electrode
100, 200: Superconducting thin film
140: In sheet

## Claims

1. A superconducting element (30) for a superconducting fault current limiter (10), comprising:
a substrate (32);
an intermediate layer (34) that is formed on the substrate (32);
a superconducting layer (36) that is formed on the intermediate layer (34); and an electrode (44) that is connected to the superconducting layer (36, 136); **characterised in that** a metal fine particle sintered layer (40) is interposed between the superconducting layer (36) and the electrode (44) that connects the superconducting layer (36) and the electrode (44),
wherein a surface roughness Ra of a surface that is in contact with the metal fine particle sintered layer (40), of a layer at a substrate side among layers adjacent to the metal fine particle sintered layer (40), is 100 nm or less; and
wherein a particle diameter of metal fine particles that form the metal fine particle sintered layer (40) is less than the surface roughness Ra.

2. The superconducting element (30) for a superconducting fault current limiter (10) according to claim 1, wherein the metal fine particle sintered layer (40) is configured with metal fine particles of a simple substance metal or alloy including at least one selected from the group consisting of Ag, Au, Cu, and Pt.

3. The superconducting element (30) for a superconducting fault current limiter (10) according to claim 1 or 2, further comprising a metal protective film (38) provided between the superconducting layer (36) and the metal fine particle sintered layer (40).

4. The superconducting element (30) for a superconducting fault current limiter (10) according to any one of claims 1 to 3, wherein the superconducting layer (36) comprises, as a main component, an oxide superconductor represented by a compositional formula of REBa₂Cu₃O_{7-δ}, wherein RE represents a single rare-earth element or a plurality of rare-earth elements, and δ is an oxygen non-stoichiometric amount.

5. The superconducting element (30) for a superconducting fault current limiter (10) according to claim 4, wherein:
the substrate (32) is a sapphire substrate; and
the intermediate layer (34) is configured to include at least one selected from the group consisting of CeO₂ and REMnO₃, wherein RE represents a single rare-earth element or a plurality of rare-earth elements.

6. A method for manufacturing a superconducting element (30) for a superconducting fault current limiter (10), the method comprising, in the following order:
an intermediate layer forming process of forming an intermediate layer (34) on a substrate (32);
a superconducting layer (36) forming process of forming a superconducting layer (36) on the intermediate layer (34);
a metal fine particle film forming process of forming a metal fine particle film containing metal fine particles on at least a part of the superconducting layer (36);
an electrode connecting process of connecting an electrode (44) to the superconducting layer (36) via the metal fine particle film; and
a sintering process of sintering the metal fine particles of the metal fine particle film to form a metal fine particle sintered layer (40),
wherein, at a stage before the metal fine particle film forming process, a surface roughness Ra of a surface that comes into contact with the metal fine particle film, of a layer adjacent to the metal fine particle film, is adjusted to 100 nm or less, and a particle diameter of the metal fine particles that are used in the metal fine particle film forming process is less than the surface roughness Ra.

7. The method for manufacturing a superconducting element (30) for a superconducting fault current limiter (10) according to claim 6, wherein the metal fine particles that are used in the metal fine particle film forming process are fine particles of a simple substance metal or alloy including at least one selected from the group consisting of Ag, Au, Cu, and Pt.

8. The method for manufacturing a superconducting element (30) for a superconducting fault current limiter (10) according to claim 6 or 7, further comprising a metal protective film forming process of forming a metal protective film (38) on the superconducting layer (36), after the superconducting layer forming process and before the metal fine particle film forming process.

9. The method for manufacturing a superconducting element (30) for a superconducting fault current limiter (10) according to any one of claims 6 to 8, wherein a superconducting layer (36) containing, as a main component, an oxide superconductor represented by a compositional formula of REBa₂Cu₃O_{7-δ}, wherein RE represents a single rare-earth element or a plurality of rare-earth elements, and δ is an oxygen non-stoichiometric amount, is formed in the superconducting layer forming process.

10. The method for manufacturing a superconducting element (30) for a superconducting fault current limiter (10) according to claim 9, wherein:
the substrate (32) is a sapphire substrate; and
an intermediate layer (34) including at least one selected from the group consisting of CeO₂ and REMnO₃, wherein RE represents a single rare-earth element or a plurality of rare-earth elements, is formed in the intermediate layer forming process.

11. A superconducting fault current limiter (10), comprising:
a sealed container (12) into which liquid nitrogen is filled;
a current input and output unit (16) that inputs a current to the inside of the sealed container (12) from the outside and outputs the current; and
a superconducting fault current limiting element (26) that is configured using the superconducting element (30) according to any one of claims 1 to 5, and is connected to the current input and output unit (16) inside the sealed container (12).

## Patentansprüche

1. Supraleitendes Element (30) für einen supraleitenden Fehlstrombegrenzer (10), mit:
einem Substrat (32);
einer Zwischenschicht (34), die auf dem Substrat (32) ausgebildet ist;
einer supraleitenden Schicht (36), die auf der Zwischenschicht (34) ausgebildet ist; und
einer Elektrode (44), die mit der supraleitenden Schicht (36, 136) verbunden ist; **dadurch gekennzeichnet, dass**
eine gesinterte Feinmetallpartikelschicht (40) zwischen der supraleitenden Schicht (36) und der Elektrode (44) angeordnet ist, die die supraleitende Schicht (36) und die Elektrode (44) verbindet,
wobei eine Oberflächenrauigkeit Ra einer Oberfläche einer substratseitig zu der gesinterten Feinmetallpartikelschicht (40) benachbarten Schicht, die mit der gesinterten Feinmetallpartikelschicht (40) in Kontakt ist, 100 nm oder weniger beträgt; und
wobei ein Partikeldurchmesser der feinen Metallpartikel, die die gesinterte Feinmetallpartikelschicht (40) ausbilden, 100 nm oder weniger ist.

2. Supraleitendes Element (30) für einen supraleitenden Fehlstrombegrenzer (10) nach Anspruch 1, wobei die gesinterte Feinmetallpartikelschicht (40) aus feinen Metallpartikeln aus einem einfachen Metall oder einer Legierung gebildet ist, wobei das Metall oder die Legierung zumindest eines aus der Gruppe gebildet aus Ag, Au, Cu und Pt umfasst.

3. Supraleitendes Element (30) für einen supraleitenden Fehlstrombegrenzer (10) nach Anspruch 1 oder 2, ferner aufweisend eine Metallschutzschicht (38), die zwischen der supraleitenden Schicht (36) und der gesinterten Feinmetallpartikelschicht (40) angeordnet ist.

4. Supraleitendes Element (30) für einen supraleitenden Fehlstrombegrenzer (10) nach einem der Ansprüche 1 bis 3, wobei die supraleitende Schicht (36) als einen Hauptbestandteil einen Oxid-Supraleiter aufweist, der durch eine Zusammensetzung REBa₂Cu₃O_{7-δ} dargestellt wird, wobei RE für ein einzelnes Seltene-Erden Element oder eine Mehrzahl an Seltene-Erden Elementen steht und δ eine nicht-stöchiometrische Menge Sauerstoff ist.

5. Supraleitendes Element (30) für einen supraleitenden Fehlstrombegrenzer (10) nach Anspruch 4, wobei:
das Substrat (32) ist ein Saphir-Substrat; und
die Zwischenschicht (34) ist derart ausgebildet, dass sie zumindest eines ausgewählt aus der Gruppe bestehend aus CeO₂ und REMnO₃ umfasst, wobei RE für ein einzelnes Seltene-Erden Element oder eine Mehrzahl an Seltene-Erden Elementen steht.

6. Verfahren zum Herstellen eines supraleitenden Elements (30) für einen supraleitenden Fehlstrombegrenzer (10), umfassend die folgenden Schritte in der angegebenen Reihenfolge:
einen Zwischenschicht-Ausbildungsprozess zum Ausbilden einer Zwischenschicht (34) auf einem Substrat (32);
einen Supraleiterschicht-Ausbildungsprozess zum Ausbilden einer supraleitenden Schicht (36) auf der Zwischenschicht (34);
einen Feinmetallpartikelschicht-Ausbildungsprozess zum Ausbilden einer Feinmetallpartikelschicht mit feinen Metallpartikeln auf zumindest einem Teilbereich der supraleitenden Schicht (36);
einen Elektroden-Verbindungsprozess zum Verbinden einer Elektrode (44) mit der supraleitenden Schicht (36) mittels der Feinmetallpartikelschicht; und
einen Sinterprozess zum Sintern der feinen Metallpartikel der Feinmetallpartikelschicht zum Ausbilden einer gesinterten Feinmetallpartikelschicht (40),
wobei eine Oberflächenrauigkeit Ra einer Oberfläche einer zu der Feinmetallpartikelschicht benachbarten Schicht, die mit der Feinmetallpartikelschicht in Kontakt kommt, zu einem Zeitpunkt vor dem Feinmetallpartikelschicht-Ausbildungsprozess, auf 100 nm oder weniger angepasst wird und wobei ein Partikeldurchmesser der feinen Metallpartikel, die in dem Feinmetallpartikelschicht-Ausbildungsprozess verwendet werden, kleiner als die Oberflächenrauheit Ra ist.

7. Verfahren zum Herstellen eines supraleitenden Elements (30) für einen supraleitenden Fehlstrombegrenzer (10) nach Anspruch 6, wobei die feinen Metallpartikel, die in dem Feinmetallpartikelschicht-Ausbildungsprozess verwendet werden, feine Partikel eines einfachen Metalls oder einer Legierung sind, wobei das Metall oder die Legierung zumindest eines ausgewählt aus der Gruppe gebildet aus Ag, Au, Cu und Pt umfasst.

8. Verfahren zum Herstellen eines supraleitenden Elements (30) für einen supraleitenden Fehlstrombegrenzer (10) nach Anspruch 6 oder 7, ferner umfassend einen Metallschutzschicht-Ausbildungsprozess zum Ausbilden einer Metallschutzschicht (38) auf der supraleitenden Schicht (36), nach dem Supraleiterschicht-Ausbildungsprozess und vor dem Feinmetallpartikelschicht-Ausbildungsprozess.

9. Verfahren zum Herstellen eines supraleitenden Elements (30) für einen supraleitenden Fehlstrombegrenzer (10) nach einem der Ansprüche 6 bis 8, wobei eine supraleitende Schicht (36), die als einen Hauptbestandteil einen Oxid-Supraleiter aufweist, der durch eine Zusammensetzung REBa₂Cu₃O_{7-δ} dargestellt wird, wobei RE für ein einzelnes Seltene-Erden Element oder eine Mehrzahl an Seltene-Erden Elementen steht und δ eine nicht-stöchiometrische Menge Sauerstoff ist, während des Supraleiterschicht-Ausbildungsprozesses ausgebildet wird.

10. Verfahren zum Herstellen eines supraleitenden Elements (30) für einen supraleitenden Fehlstrombegrenzer (10) nach Anspruch 9, wobei:
das Substrat (32) ist ein Saphir-Substrat; und
eine Zwischenschicht (34) umfassend zumindest eines ausgewählt aus der Gruppe bestehend aus CeO₂ und REMnO₃ umfasst, wobei RE für ein einzelnes Seltene-Erden Element oder eine Mehrzahl an Seltene-Erden Elementen steht, während des Zwischenschicht-Ausbildungsprozesses ausgebildet wird.

11. Supraleitender Fehlstrombegrenzer (10), umfassend:
einen abgedichteten Behälter (12), der mit flüssigem Stickstoff befüllt ist;
eine Stromzuführungs- und -ausgabeeinheit (16), die einen Strom von außen dem Inneren des Behälters (12) zuführt und den Strom ausgibt; und
ein supraleitendes fehlstrombegrenzendes Element (26), das mit Hilfe eines supraleitenden Elements (30) nach einem der Ansprüche 1 bis 5 ausgebildet ist und das mit der Stromzuführungs- und -ausgabeeinheit (16) in dem abgedichteten Behälter (12) verbunden ist.

## Revendications

1. Élément supraconducteur (30) pour un limiteur de courant de défaut supraconducteur (10), comprenant :
un substrat (32) ;
une couche intermédiaire (34) qui est formée sur le substrat (32) ;
une couche supraconductrice (36) qui est formée sur la couche intermédiaire (34) ; et,
une électrode (44) qui est connectée à la couche supraconductrice (36, 136) ;
**caractérisé en ce qu'**une couche frittée de fines particules métalliques (40) est intercalée entre la couche supraconductrice (36) et l'électrode (44) qui connecte la couche supraconductrice (36) et l'électrode (44),
dans lequel une rugosité de surface Ra d'une surface qui est en contact avec la couche frittée de fines particules métalliques (40), d'une couche sur un côté substrat parmi les couches adjacentes à la couche frittée de fines particules métalliques (40), est de 100 nm ou moins ; et
dans lequel un diamètre de particule des fines particules métalliques qui forment la couche frittée de fines particules métalliques (40) est inférieur à la rugosité de surface Ra.

2. Élément supraconducteur (30) pour un limiteur de courant de défaut supraconducteur (10) selon la revendication 1, dans lequel la couche frittée de fines particules métalliques (40) est configurée avec de fines particules métalliques d'un métal ou alliage de substance simple incluant au moins l'un des éléments choisi dans le groupe constitué d'Ag, d'Au, de Cu, et de Pt.

3. Élément supraconducteur (30) pour un limiteur de courant de défaut supraconducteur (10) selon la revendication 1 ou 2, comprenant en outre un fil de protection métallique (38) disposé entre la couche supraconductrice (36) et la couche frittée de fines particules métalliques (40).

4. Élément supraconducteur (30) pour un limiteur de courant de défaut supraconducteur (10) selon l'une quelconque des revendications 1 à 3, dans lequel la couche supraconductrice (36) comprend, comme composant principal, un oxyde supraconducteur représenté par une formule de composition de REBa₂Cu₃O_{7-δ}, dans laquelle RE représente un métal des terres rares unique ou une pluralité de métaux des terres rares, et δ est une quantité non-stoechiométrique d'oxygène.

5. Élément supraconducteur (30) pour un limiteur de courant de défaut supraconducteur (10) selon la revendication 4, dans lequel :
le substrat (32) est un substrat en saphir ; et
la couche intermédiaire (34) est configurée pour inclure au moins un élément choisi dans le groupe constitué de CeO₂ et de REMnO₃, dans lequel RE représente un métal des terres rares unique ou une pluralité de métaux des terres rares.

6. Procédé de fabrication d'un élément supraconducteur (30) pour un limiteur de courant de défaut supraconducteur (10), le procédé comprenant, dans l'ordre suivant :
un processus de formation de couche intermédiaire consistant à former une couche intermédiaire (34) sur un substrat (32) ;
un processus de formation de couche supraconductrice (36) consistant à former une couche supraconductrice (36) sur la couche intermédiaire (34) ;
un processus de formation de film de fines particules métalliques consistant à former un film de fines particules métalliques contenant de fines particules métalliques sur au moins une partie de la couche supraconductrice (36) ;
un processus de connexion d'électrode consistant à connecter une électrode (44) à la couche supraconductrice (36) via le film de fines particules métalliques ; et
un processus de frittage consistant à fritter les fines particules métalliques du film de fines particules métalliques afin de former une couche frittée de fines particules métalliques (40),
dans lequel, à une étape avant le processus de formation de film de fines particules métalliques, une rugosité de surface Ra d'une surface qui vient en contact avec le film de fines particules métalliques, d'une couche adjacente au film de fines particules métalliques, est ajustée à 100 nm ou moins, et un diamètre de particule de fines particules métalliques qui sont utilisées dans le processus de formation de film de fines particules métalliques est inférieur à la rugosité de surface Ra.

7. Procédé de fabrication d'un élément supraconducteur (30) pour un limiteur de courant de défaut supraconducteur (10) selon la revendication 6, dans lequel les fines particules métalliques qui sont utilisées dans le processus de formation de film de fines particules métalliques sont de fines particules d'un métal ou alliage de substance simple incluant au moins l'un des éléments choisi dans le groupe constitué d'Ag, d'Au, de Cu, et de Pt.

8. Procédé de fabrication d'un élément supraconducteur (30) pour un limiteur de courant de défaut supraconducteur (10) selon la revendication 6 ou 7, comprenant en outre un processus de formation de film de protection métallique consistant à former un film de protection métallique (38) sur la couche supraconductrice (36), après le processus de formation de couche supraconductrice et avant le processus de formation de film de fines particules métalliques.

9. Procédé de fabrication d'un élément supraconducteur (30) pour un limiteur de courant de défaut supraconducteur (10) selon l'une quelconque des revendications 6 à 8, dans lequel une couche supraconductrice (36) contenant, comme composant principal, un oxyde supraconducteur représenté par une formule de composition de REBa₂Cu₃O₇₋₆, dans laquelle RE représente un métal des terres rares unique ou une pluralité de métaux des terres rares, et δ est une quantité non-stoechiométrique d'oxygène, est formée dans le processus de formation de couche supraconductrice.

10. Procédé de fabrication d'un élément supraconducteur (30) pour un limiteur de courant de défaut supraconducteur (10) selon la revendication 9, dans lequel :
le substrat (32) est un substrat en saphir ; et
une couche intermédiaire (34) incluant au moins un élément choisi dans le groupe constitué de CeO₂ et de REMnO₃, dans lequel RE représente un métal des terres rares unique ou une pluralité de métaux des terres rares, est formée dans le processus de formation de couche intermédiaire.

11. Limiteur de courant de défaut supraconducteur (10), comprenant :
un récipient scellé (12) dans lequel on a introduit de l'azote liquide ;
une unité d'entrée et de sortie de courant (16) qui fait entrer un courant à l'intérieur du récipient scellé (12) depuis l'extérieur et fait sortir le courant ; et
un élément limiteur de courant de défaut supraconducteur (26) qui est configuré au moyen de l'élément supraconducteur (30) selon l'une quelconque des revendications 1 à 5, et est connecté à l'unité d'entrée et de sortie de courant (16) à l'intérieur du récipient scellé (12).
